# EUROPEAN PATENT SPECIFICATION

(11) **EP 2 419 489 B1**
(45) Date of publication and mention of the grant of the patent: **09.08.2017**
(21) Application number: 10715326.4
(22) Date of filing: 15.04.2010
(51) Int. Cl.: C09K 11/06, H05B 33/14

(54) **ORGANIC LIGHT-EMITTING MATERIALS AND DEVICES**
ORGANISCHE LICHT EMITTIERENDE MATERIALIEN UND VORRICHTUNGEN
MATÉRIAUX ET DISPOSITIFS ORGANIQUES ÉLECTROLUMINESCENTS

(30) Priority: 16.04.2009 GB 0906588
(43) Date of publication of application: 22.02.2012
(73) Proprietor: Cambridge Display Technology Limited, Cardinal Way Godmanchester Cambridgeshire PE29 2XG (GB); Sumitomo Chemical Company Limited, Tokyo 104-8260 (JP)
(72) Inventor: PILLOW, Jonathan, Cambridgeshire CB23 6DW (GB); GRIZZI, Ilaria, Cambridgeshire CB23 6DW (GB); HUMPHRIES, Martin, Cambridgeshire CB23 6DW (GB); WARBURTON, Ian, Cambridgeshire CB23 6DW (GB)
(74) Representative: Gilani, Anwar
(86) International application number: PCT/GB2010/000802
(87) International publication number: WO 2010/119276

(56) References cited:
- WO-A1-2007/072741
- US-A1- 2007 244 295
- S.BECKER ET.AL.: "Optimisation of polyfluorenes for light emitting applications" SYNTHETIC METALS, vol. 125, 2002, pages 73-80, XP002589748
- C. EGO ET.AL.: "Attaching perylene dyes to polyfluorene: three simple, efficient methods for facile color tuning of light-emitting polymers" J. AM. CHEM. SOC., vol. 125, 2003, pages 473-443, XP002589749
- G. KLÄRNER ET.AL.: "Exciton migration and trapping in coplymers based on dialylfluorenes" ADV. MATER., vol. 11, 1999, pages 115-119, XP002589750
- J. LEE ET.AL.: "Color tuning in polyfluorrenes by copolymerization with low bans gap comonomers" SYNTHETIC METALS, vol. 102, 1999, pages 1087-1088, XP002589751

## Description

### Field of the Invention

The present invention is concerned with organic light-emitting materials and organic light-emitting devices containing such materials.

### Background of the Invention

A typical organic light-emitting device (OLED) comprises a substrate, on which is supported an anode, a cathode and a light-emitting layer situated in between the anode and cathode and comprising at least one organic electroluminescent material. In operation, holes are injected into the device through the anode and electrons are injected into the device through the cathode. The holes and electrons combine in the light-emitting layer to form an exciton which then undergoes radioactive decay to emit light.

Other layers may be present in the OLED, for example a layer of hole injection material, such as poly(ethylene dioxythiophene)/polystyrene sulphonate (PEDOT/PSS), may be provided between the anode and the light-emitting layer to assist injection of holes from the anode to the light-emitting layer. Further, a hole transport layer may be provided between the anode and the light-emitting layer to assist transport of holes to the light-emitting layer.

Electroluminescent polymers such as conjugated polymers are an important class of materials that will be used in organic light emitting devices for the next generation of information technology based consumer products. The principle interest in the use of polymers, as opposed to inorganic semiconducting and organic dye materials, lies in the scope for low-cost device manufacturing, using solution-processing of film-forming materials. A further advantage of electroluminescent polymers is that they may be readily formed by Suzuki or Yamamoto polymerisation. This enables a high degree of control over the regioregulatory of the resultant polymer.

Since the last decade much effort has been devoted to the improvement of the emission efficiency of organic light- emitting devices either by developing highly efficient materials or efficient device structures. In addition, much effort has been devoted to the improvement in lifetime of organic light-emitting devices, again by developing new materials or device structures. A particular problem has been the low lifetime of blue organic light-emissive materials. Some examples of light-emissive materials known in the art are discussed below.

"Synthesis of a segmented conjugated polymer chain giving a blue-shifted electroluminescence and improved efficiency" by P.L. Burn, A.B. Holmes, A. Kraft, D.D.C. Bradley, A.R. Brown and R. H. Friend, J.Chem. Soc., Chem. Commun., 1992, 32 described the preparation of a light-emitting polymer that had conjugated and non-conjugated sequences in the main chain and exhibited blue-green electroluminescence with an emission maximum at 508 nm. Blue light-emission was observed in two conjugated polymers. Poly(p-phenylene) sandwiched between indium-tin oxide and aluminium contacts has been published by G. Grem, G. Leditzky, B. Ullrich and G. Leising in Adv. Mater.. 1992, 4, 36. Similarly, Y. Ohmori, M. Uchida, K. Muro and K. Yoshino reported on "Blue electroluminescent diodes utilizing poly(alkylfluorene)" in Jpn. J. Appl. Phys., 1991, 30, L1941.

Applied Physics Letters, Vol. 75, No. 26, 27 December 1999, 4055-4057 "Reduction of molecular aggregation and its application to the high-performance blue perylene-doped organic electroluminescent device" discloses electroluminescent devices made using perylene as a dopant in bis(2-methyl-8-quinolinolato)(para-phenylphenolato) aluminium (III).

J. Am. Chem. Soc., 2003, 125, 437-443 "Attaching Perylene Dyes to Polyfluorene: Three Simple, Efficient Methods for Facile Color Tuning of Light-Emitting Polymers" discloses attachment of perylene dyes to polyfluorene chains either as (i) comonomers in the main chain, (ii) as endcapping groups at the chain termini, or (iii) as pendant side groups.

Polymer (Korea), 2004, 28(5), 367-373 "Electroluminescence characteristics of blue light emitting copolymer containing perylene and triazine moieties in the side chain" discloses blue light emitting copolymers containing perylene and triazine moieties as light emitting and electron transporting units in the polymer side chain.

Chem. Commun., 2005, 2172-2174 " Selective Ir-catalysed borylation of polycyclic aromatic hydrocarbons: structures of naphthalene-2,6-bis(boronate), pyrene-2,7-bis(boronate) and perylene-2,5,8,11-tetra(boronate) esters" discloses the production of pyrene-bis(boronate) and perylene-tetra(boronate) esters to produce conjugated systems and optical materials. WO 2005/043640 discloses that blending a perylene derivative with an organic light-emissive material in an organic light-emissive device can give a small increase in the lifetime of the device. However, while higher concentrations of perylene derivative give greater improvements in lifetime this results in a significant red-shift in the emission spectrum.

Synthetic Metals, vol.125, 2002, pp 73-80, S. Becker et al., 'Optimisation of polyfluorenes for light emitting applications' describes polyfluorenes for use in luminescent devices where their conjugation length may be extended by using more planar indenofluorene units.

In light of the above, it is apparent that it is known to incorporate polycyclic aromatic hydrocarbons such as perylene derivatives into a light-emissive polymer in order to act as light-emissive units. It is also apparent that it is known to blend perylene derivatives with organic light-emissive material in an organic light- emissive device in order to increase the lifetime of the device but that only small increases in lifetime are observed and at the expense of a significant red-shift in the emission spectrum.

It is an aim of embodiments of the present invention to provide materials which result in a much larger improvement in the lifetime of organic light-emissive devices while not significantly changing their emission spectrum.

### Summary of the present Invention

The present applicant has surprising found that incorporating large polycyclic aromatic hydrocarbon units, i.e. those with greater than 12 aromatic sp2 hybridized carbon atoms, as non-emissive units in a light-emissive polymer significantly increases the lifetime of the light-emissive polymer without leading to a large change in the emission spectrum of the light-emissive polymer when compared with merely blending such units with a light-emissive polymer.

In light of this finding, and in accordance with a first aspect of the present invention, there is provided a conjugated, blue-light emitting electroluminescent polymer comprising light-emissive repeat units and a non-emissive polycyclic aromatic hydrocarbon unit with greater than 12 aromatic sp2 hybridized carbon atoms, wherein the non-emissive polycyclic aromatic hydrocarbon unit comprises a structural unit having formula II: 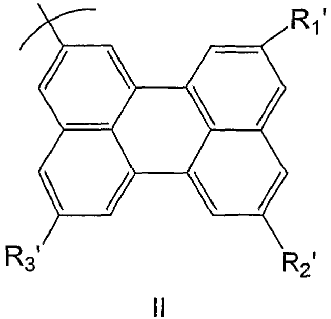 wherein R₁', R₂', and R₃' each independently represent an optional substituent, and the non-emissive polycyclic aromatic hydrocarbon unit is covalently bound as a side chain to the electroluminescent polymer main chain.

There are several possible explanations as to why the incorporation of a large non-emissive polycyclic aromatic hydrocarbon unit into an electroluminescent polymer increases the lifetime of the electroluminescent polymer without significantly changing its emission spectrum. Without being bound by theory, one possible explanation is that the large polycyclic aromatic hydrocarbon unit provides a rigid conjugated system having a large surface area which allows for improved charge transfer along the polymer. This may explain why incorporating the units as non-emissive charge transporting units within an emissive polymer rather them merely mixing the units as a blend with an emissive material provides such an improvement. By incorporating the units into the polymer the large plate-like units can align in a face-to-face orientation to provide good charge transport along the length of the polymer as opposed to being randomly orientated in a blend. Alternatively, or additionally, by incorporating the large
non-emissive polycyclic aromatic hydrocarbon unit into an electroluminescent polymer they are more closely associated with the emissive units and thus function more efficiently at transferring charge to the emissive units.

Furthermore, the large polycyclic aromatic hydrocarbon units appear to have a relatively localized band gap such that they have little effect on the conjugation of the rest of the emissive polymer and thus there is negligible change in the colour of emission. There is substantially no emission from the large polycyclic aromatic hydrocarbon units. This can be ensured, for example, by selecting the large polycyclic aromatic hydrocarbon units and the emissive units such that the band gap of the large polycyclic aromatic hydrocarbon units is larger than the band gap of the emissive units.

It has also been verified by the present applicant that the advantageous effects of the present invention are not achieved by incorporating smaller charge transporting units having a similar band gap to that of the large polycyclic aromatic hydrocarbon units of the present invention. This would appear to support the previously described hypothesis that it is the size of the large plate- like units which is responsible for the observed advantageous effects.

The large polycyclic aromatic hydrocarbon units are incorporated into the one or more side chains pendant to the polymer main chain. The large polycyclic aromatic hydrocarbon units can also optionally be incorporated into the main chain of the electroluminescent polymer as a repeat unit and/or as end capping groups of the polymer main chain. It has been surprising found that even if only a small number of large polycyclic aromatic hydrocarbon units are incorporated into the electroluminescent polymer a significant increase in lifetime is observed. Thus the concentration of the large polycyclic aromatic hydrocarbon units in the electroluminescent polymer may be less than 10mol% of the total moles of repeat units in the polymer, more preferably less than 2mol%, more preferably still 1mol% or less and even less than 0.5mol%. Thus, very small loadings of the large polycyclic aromatic hydrocarbon units (such as in the range 0.001 to 1mol%) can be used to give significant increases in lifetime without significantly changing the colour of emission.

The emissive units may preferably be selected from any emissive units which have a smaller band gap than the large polycyclic aromatic hydrocarbon units.

Preferably, the electroluminescent polymer further comprises charge transporting repeat units and the band gap of the non-emissive polycyclic aromatic hydrocarbon unit is intermediate in energy between the charge transporting repeat units and the light-emissive repeat units. In this arrangement, the non- emissive polycyclic aromatic hydrocarbon unit can function to transfer charge from the charge transporting repeat units to the light-emissive repeat units. The charge transporting repeat units may comprise hole transporting and/or electron transporting repeat units. The charge transporting repeat units may comprise a fluorene based repeat unit and/or a triaryl amine based repeat unit.

The electroluminescent polymer is blue-light emitting. As previously mentioned in the background section, the low lifetime of blue light- emitting polymers is a particular problem to which certain embodiments of the present invention are directed.

For the purposes of the present invention, the term "blue-light emitting" means that the photoluminescent light emission has a peak wavelength in the range of from 400 to 500 nm, preferably 430 to 500 nm.

The non-emissive polycyclic aromatic hydrocarbon unit preferably comprises one or more substituents. Examples of substituents include solubilising groups such as C₁₋₂₀ alkyl or alkoxy; electron withdrawing groups such as fluorine, nitro or cyano; substituents for increasing glass transition temperature (Tg) of the polymer; and aryl groups such as optionally substituted phenyl, unsubstituted phenyl or phenyl substituted with one or more alkyl or alkoxy groups. A preferred substituent is t-butyl.

When suitably positioned, substituents can act to protect the fused aromatic rings of the non-emissive polycyclic aromatic hydrocarbon unit, for example by blocking reactive sites of the non-emissive polycyclic aromatic hydrocarbon unit. They may also serve to prevent aggregation of the material.

Optionally, substituents present on the non-emissive polycyclic aromatic hydrocarbon unit may be linked together, either by a direct bond or by a linking group or linking atom.

### Brief description of the Drawings

The present invention will now be described by way of example only with reference to the following drawings:
Figure 1 shows an organic light emissive device in accordance with an embodiment of the present invention;
Figure 2 shows a graph illustrating luminance vs time plots for several polymers according to the present invention in which large non-emissive polycyclic aromatic hydrocarbon units have been incorporated and also, for comparison, corresponding polymers without large non-emissive polycyclic aromatic hydrocarbon units incorporated therein;
Figure 3 shows the emission spectra of the polymers of Figure 2;
Figure 4 shows a graph illustrating luminance vs time plots for a polymer only (solid lines) and a polymer blended with perylene (dotted lines); and
Figure 5 shows a graph illustrating luminance vs time plots for a polymer only (solid lines) and a polymer according to the present invention in which non- emissive perylene derivative units have been incorporated (dotted lines).

### Detailed description of Embodiments

The non-emissive polycyclic aromatic hydrocarbon unit comprises a structual unit having the following formula II and is substituted at any one or more of the positions C2, C5, and C8, as shown below in formula II: 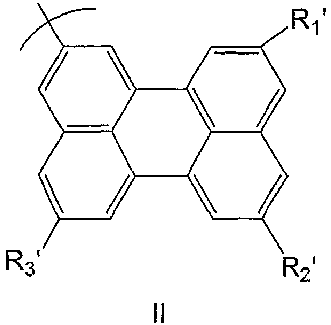 where R₁', R₂', and R₃' each independently represent an optional substituent, as defined above, wherein R₁'-R₃' are optional substituents independently selected from the group consisting of alkyl, optionally substituted aryl, alkoxy, thioether and amine. Preferred substituents are alkyl, more preferably branched alkyl; and phenyl, more preferably alkylsubstituted phenyl. In one preferred embodiment, all of substituents R₁', R₂', and R₃' are present. R₁', R₂', and R₃' can act to protect the fused rings of the non- emissive polycyclic aromatic hydrocarbon. Preferably, each of R₁', R₂', and R₃' represents t-butyl.

The non-emissive polycyclic aromatic hydrocarbon (PAH) may be connected to the backbone of the electroluminescent polymer via a spacer group, as shown by the repeat unit in formula III:

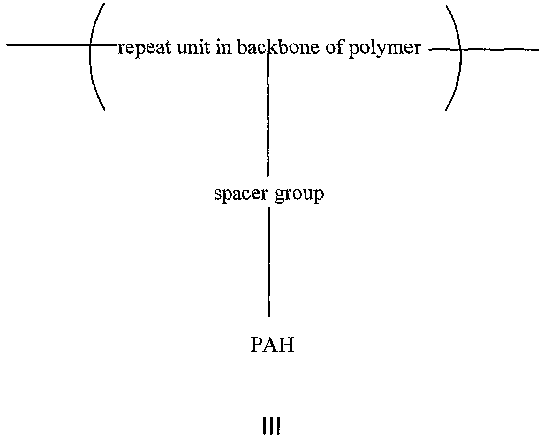

A spacer group may be conjugated or non-conjugated.

Conjugated spacer groups include phenyl, for example. Non-conjugated spacer groups include alkyl, for example.

The non-emissive polycyclic aromatic hydrocarbon may also be directly linked to the polymer backbone.

The backbone of the electroluminescent polymer may comprise one or more different repeat units.

In one embodiment, it is preferred that the repeat unit in the backbone of the polymer, to which the non-emissive polycyclic aromatic hydrocarbon is bound, comprises a fluorene, more preferably a 9,9 disubstituted fluorene. The fluorene unit provides stability to the repeat unit as a whole.

When the non-emissive polycyclic aromatic hydrocarbon is bound to the electroluminescent polymer, the electroluminescent polymer may comprise a repeat unit having formula IV:

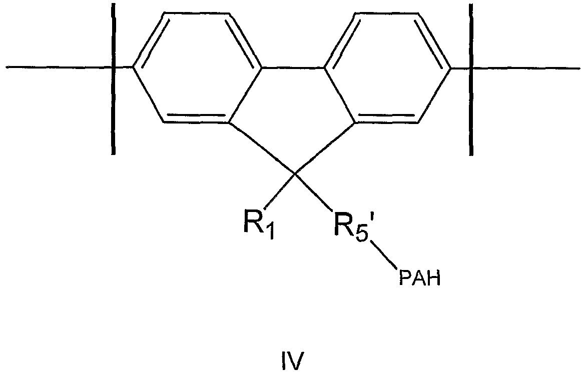

Preferred repeat units having formula IV are shown in formulae V to VIII: 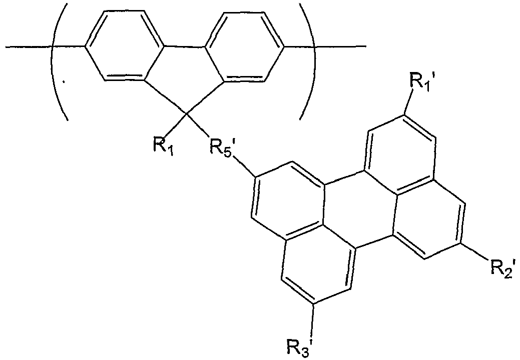 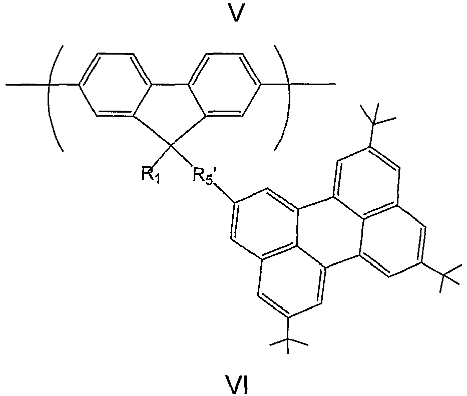 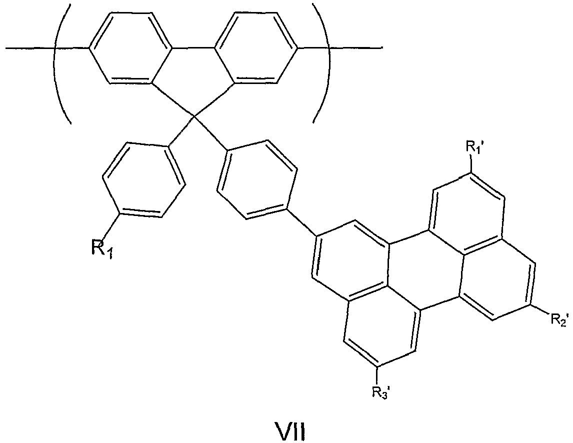 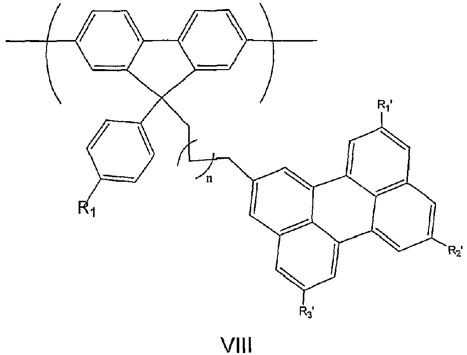 where R₁, R₁', R₂', and R₃' are as defined above; R₅'is a spacer group, preferably alkylene, arylene (in particular phenylene), oxygen, nitrogen, sulphur or combinations thereof, in particular arylalkyl; and n is from 1-10. Preferably, R₁ represents an optionally substituted C₄-C₂₀ alkyl or aryl group.

The polymer preferably contains up to 5 mol% of a repeat unit having one of formulae III to VIII above, more preferably 0.1 to 2 mol%, still more preferably about 0.2-0.5 mol%.

Some examples of suitable polycyclic aromatic hydrocarbon monomers for manufacturing the electroluminescent polymers of the present invention are given below:

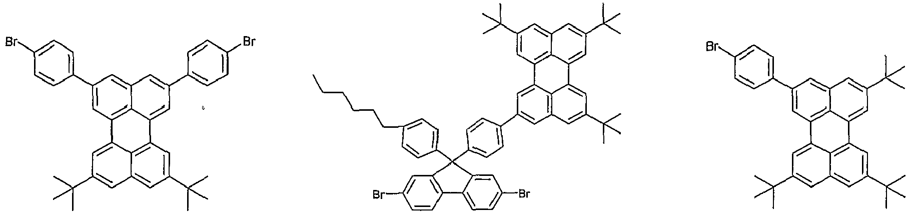

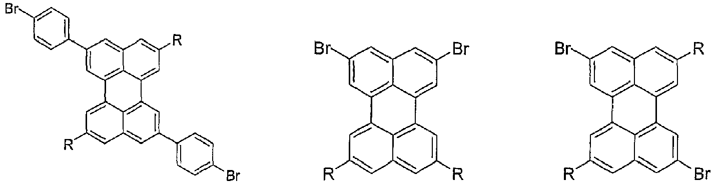

Preferred electron transporting repeat units comprise fluorene. The term "fluorene" used herein includes spirofluorene and indenofluorene within its meaning. In order to optimise electron transport, fluorene units are preferably connected in chains of three or more along the polymer backbone, as is known in the art.

A preferred electron transporting repeat unit comprises an optionally substituted 2,7-linked fluorene, most preferably having formula I: 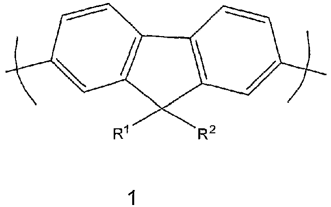 wherein R¹ and R² are independently selected from hydrogen or optionally substituted alkyl, alkoxy, aryl, arylalkyl, heteroaryl and heteroarylalkyl. More preferably, at least one of R¹ and R² comprises an optionally substituted C₄-C₂₀ alkyl or aryl group.

Preferred hole transporting repeat units comprise amine, in particular, a triarylamine, preferably having formula 2: 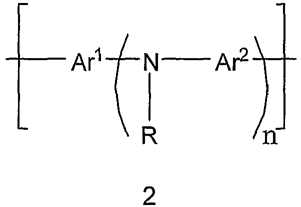 wherein Ar¹ and Ar² are optionally substituted aryl or heteroaryl groups, n is greater than or equal to 1, preferably 1 or 2, and R is H or a substituent, preferably a substituent. R is preferably alkyl or aryl or heteroaryl, most preferably aryl or heteroaryl. Any of the aryl or heteroaryl groups in the unit of formula 2 may be substituted. Preferred substituents include alkyl and alkoxy groups. Any of the aryl or heteroaryl groups in the repeat unit of Formula 2 may be linked by a direct bond or a divalent linking atom or group. Preferred divalent linking atoms and groups include O, S; substituted N; and substituted C.

Particularly preferred units satisfying formula 2 include units of formulae 3 to 5: 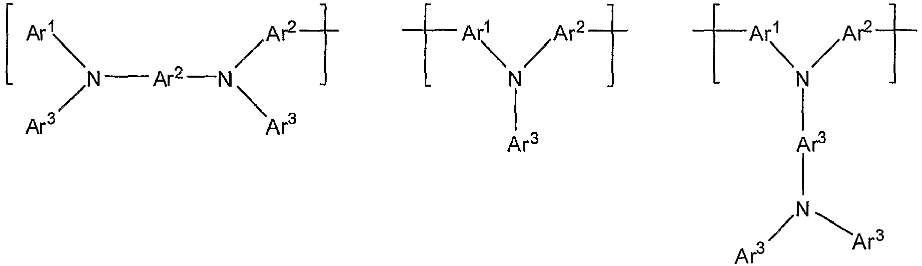 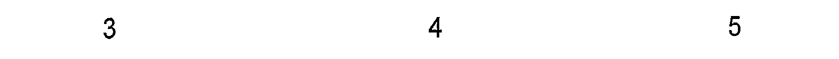 wherein Ar¹ and Ar² are as defined above; and Ar³ is optionally substituted aryl or heteroaryl. Where present, preferred substituents for Ar³ include alkyl and alkoxy groups.

A second aspect of the present invention provides a method for making a material as defined in relation to the first aspect of the present invention.

Preferred methods for preparation of the conjugated polymer are Suzuki polymerisation as described in, for example, WO 00/53656 and Yamamoto polymerisation as described in, for example, T. Yamamoto, "Electrically Conducting And Thermally Stable Π - Conjugated Poly(arylene)s Prepared by Organometallic Processes", Progress in Polymer Science 1993, 17, 1153-1205. These polymerisation techniques both operate via a "metal insertion" wherein the metal atom of a metal complex catalyst is inserted between an aryl group and a leaving group of a monomer. In the case of Yamamoto polymerisation, a nickel complex catalyst is used; in the case of Suzuki polymerisation, a palladium complex catalyst is used.

For example, in the synthesis of a linear polymer by Yamamoto polymerisation, a monomer having two reactive halogen groups is used. Similarly, according to the method of Suzuki polymerisation, at least one reactive group is a boron derivative group such as a boronic acid or boronic ester and the other reactive group is a halogen. Preferred halogens are chlorine, bromine and iodine, most preferably bromine.

It will therefore be appreciated that repeat units and end groups comprising aryl groups as illustrated throughout this application may be derived from a monomer carrying a suitable leaving groups.

Suzuki polymerisation may be used to prepare regioregular, block and random copolymers. In particular, homopolymers or random copolymers may be prepared when one reactive group is a halogen and the other reactive group is a boron derivative group. Alternatively, block or regioregular, in particular AB, copolymers may be prepared when both reactive groups of a first monomer are boron and both reactive groups of a second monomer are halogen.

As alternatives to halides, other leaving groups capable of participating in metal insertion include groups include tosylate, mesylate and triflate.

The second aspect thus provides a method for making a material as defined in relation to the first aspect of the present invention using Suzuki polymerisation or Yamamoto polymerisation whereby monomers are polymerised, each monomer having at least two reactive groups. Preferably, the reactive groups are selected from boron derivative groups such as a boronic acid or boronic ester, halogen, tosylate, mesylate and triflate.

A third aspect of the present invention provides an organic light-emitting device (OLED) containing a material as defined in relation to the first aspect of the present invention. Typically, said material will be comprised in a layer of the device either alone of in combination with one or more other materials. The device may, for example, consist of one or more diodes.

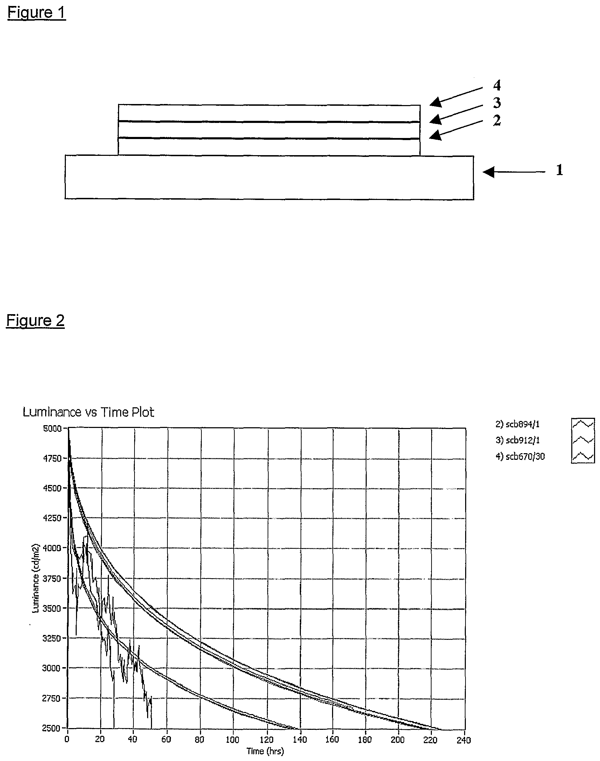

With reference to Figure 1, the architecture of an OLED according to the third aspect of the invention typically comprises a transparent glass or plastic substrate 1, an anode 2 and a cathode 4. An electroluminescent layer 3 comprising the light-emitting material as defined in relation to the first aspect is provided between anode 2 and cathode 4.

In a practical device, at least one of the electrodes is semi-transparent in order that light may be absorbed (in the case of a photoresponsive device) or emitted (in the case of an OLED). Where the anode is transparent, it typically comprises indium tin oxide.

Further layers may be located between anode 2 and cathode 3, such as charge transporting, charge injecting or charge blocking layers.

In particular, it is desirable to provide a conductive hole injection layer, which may be formed from a conductive organic or inorganic material provided between the anode 2 and the electroluminescent layer 3 to assist hole injection from the anode into the layer or layers of semiconducting polymer. Examples of doped organic hole injection materials include doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and poly(thienothiophene). Examples of conductive inorganic materials include transition metal oxides such as VOx MoOx and RuOx as disclosed in Journal of Physics D: Applied Physics (1996), 29(11), 2750-2753.

If present, a hole transporting layer located between anode 2 and electroluminescent layer 3 preferably has a HOMO level of less than or equal to 5.5 eV, more preferably around 4.8-5.5 eV. HOMO levels may be measured by cyclic voltammetry, for example.

If present, an electron transporting layer located between electroluminescent layer 3 and cathode 4 preferably has a LUMO level of around 3-3.5 eV.

Electroluminescent layer 3 may consist of the light-emitting material alone or may comprise the light-emitting material in combination with one or more further materials. In particular, the light-emitting material may be blended with hole and/or electron transporting materials as disclosed in, for example, WO 99/48160, or may comprise a luminescent dopant in a semiconducting host matrix. Alternatively, the light-emitting material may be covalently bound to a charge transporting material and/or host material.

Cathode 4 is selected from materials that have a workfunction allowing injection of electrons into the electroluminescent layer. Other factors influence the selection of the cathode such as the possibility of adverse interactions between the cathode and the electroluminescent material. The cathode may consist of a single material such as a layer of aluminium. Alternatively, it may comprise a plurality of metals, for example a bilayer of a low workfunction material and a high workfunction material such as calcium and aluminium as disclosed in WO 98/10621; elemental barium as disclosed in WO 98/57381, Appl. Phys. Lett. 2002, 81(4), 634 and WO 02/84759; or a thin layer of metal compound, in particular an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode will comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

Optical devices tend to be sensitive to moisture and oxygen. Accordingly, the substrate preferably has good barrier properties for prevention of ingress of moisture and oxygen into the device. The substrate is commonly glass, however alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850.

The device is preferably encapsulated with an encapsulant (not shown) to prevent ingress of moisture and oxygen. Suitable encapsulants include a sheet of glass, films having suitable barrier properties such as alternating stacks of polymer and dielectric as disclosed in, for example, WO 01/81649 or an airtight container as disclosed in, for example, WO 01/19142. A getter material for absorption of any atmospheric moisture and / or oxygen that may permeate through the substrate or encapsulant may be disposed between the substrate and the encapsulant.

The embodiment of Figure 1 illustrates a device wherein the device is formed by firstly forming an anode on a substrate followed by deposition of an electroluminescent layer and a cathode, however it will be appreciated that the device of the invention could also be formed by firstly forming a cathode on a substrate followed by deposition of an electroluminescent layer and an anode.

A fourth aspect of the present invention provides a method of making an OLED as defined in relation to the third aspect. Preferably, the light-emitting material as defined in relation to the first aspect is deposited (optionally in combination with one or more further materials) from solution by solution processing to form a layer of the OLED.

Suitable solvents for polyarylenes, in particular polyfluorenes, include mono- or poly-alkylbenzenes such as toluene and xylene. Particularly preferred solution deposition techniques are spin-coating and inkjet printing.

Spin-coating is particularly suitable for devices wherein patterning of the electroluminescent material is unnecessary - for example for lighting applications or simple monochrome segmented displays.

Inkjet printing is particularly suitable for high information content displays, in particular full colour displays. Inkjet printing of OLEDs is described in, for example, EP 0880303.

Other solution deposition techniques include dip-coating, roll printing and screen printing.

If multiple layers of the OLED are formed by solution processing then the skilled person will be aware of techniques to prevent intermixing of adjacent layers, for example by crosslinking of one layer before deposition of a subsequent layer or selection of materials for adjacent layers such that the material from which the first of these layers is formed is not soluble in the solvent used to deposit the second layer.

A fifth aspect of the present invention provides a light source such as a full colour display comprising a device as defined in relation to the third aspect of the invention.

According to the fifth aspect, electroluminescent layer 3 may be patterned or unpatterned. A device comprising an unpatterned layer may be used an illumination source, for example. A white light emitting device is particularly suitable for this purpose. A device comprising a patterned layer may be, for example, an active matrix display or a passive matrix display. In the case of an active matrix display, a patterned electroluminescent layer is typically used in combination with a patterned anode layer and an unpatterned cathode. In the case of a passive matrix display, the anode layer is formed of parallel stripes of anode material, and parallel stripes of electroluminescent material and cathode material arranged perpendicular to the anode material wherein the stripes of electroluminescent material and cathode material are typically separated by stripes of insulating material ("cathode separators") formed by photolithography.

Referring to the device according to the third aspect, the following general comments may be made regarding conjugated polymers.

Electroluminescent and/or charge transporting polymers include poly(arylene vinylenes) such as poly(p-phenylene vinylenes) and polyarylenes.

Polymers preferably comprise a first repeat unit selected from arylene repeat units as disclosed in, for example, Adv. Mater. 2000 12(23) 1737-1750 and references therein. Exemplary first repeat units include: 1,4-phenylene repeat units as disclosed in J. Appl. Phys. 1996, 79, 934; fluorene repeat units as disclosed in EP 0842208; indenofluorene repeat units as disclosed in, for example, Macromolecules 2000, 33(6), 2016-2020; and spirofluorene repeat units as disclosed in, for example EP 0707020. Each of these repeat units is optionally substituted. Examples of substituents include solubilising groups such as C₁₋₂₀ alkyl or alkoxy; electron withdrawing groups such as fluorine, nitro or cyano; and substituents for increasing glass transition temperature (Tg) of the polymer.

Particularly preferred polymers comprise optionally substituted, 2,7-linked fluorenes, most preferably repeat units of formula 6: 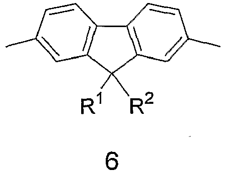 wherein R¹ and R² are independently selected from hydrogen or optionally substituted alkyl, alkoxy, aryl, arylalkyl, heteroaryl and heteroarylalkyl. More preferably, at least one of R¹ and R² comprises an optionally substituted C₄-C₂₀ alkyl or aryl group.

Polymers may provide one or more of the functions of hole transport, electron transport and emission depending on which layer of the device it is used in and the nature of co-repeat units.

In particular:
- a homopolymer of fluorene repeat units, such as a homopolymer of 9,9-dialkylfluoren-2,7-diyl, may be utilised to provide electron transport.
- a copolymer comprising triarylamine repeat unit, in particular a repeat unit 7: 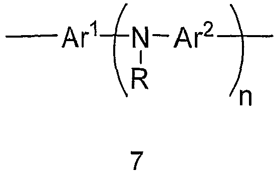 wherein Ar¹ and Ar² are optionally substituted aryl or heteroaryl groups, n is greater than or equal to 1, preferably 1 or 2, and R is H or a substituent, preferably a substituent. R is preferably alkyl or aryl or heteroaryl, most preferably aryl or heteroaryl. Any of the aryl or heteroaryl groups in the unit of formula 1 may be substituted. Preferred substituents include alkyl and alkoxy groups. Any of the aryl or heteroaryl groups in the repeat unit of Formula 1 may be linked by a direct bond or a divalent linking atom or group. Preferred divalent linking atoms and groups include O, S; substituted N; and substituted C.

Particularly preferred units satisfying Formula 1 include units of Formulae 8-10: 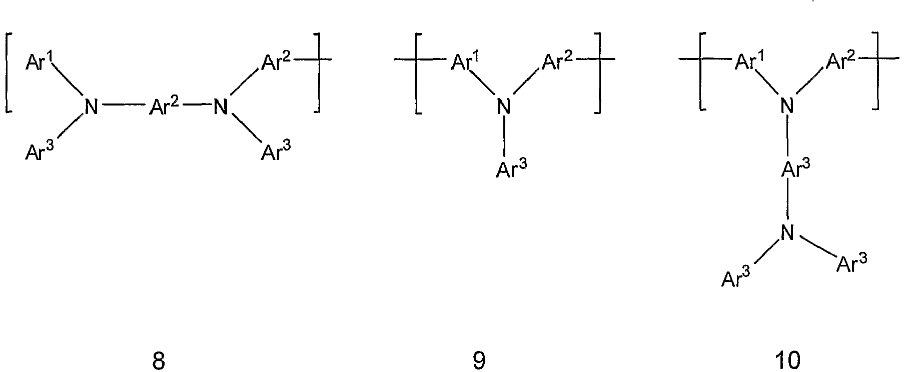 wherein Ar¹ and Ar² are as defined above; and Ar³ is optionally substituted aryl or heteroaryl. Where present, preferred substituents for Ar³ include alkyl and alkoxy groups.

Particularly preferred hole transporting polymers of this type are copolymers of the first repeat unit and a triarylamine repeat unit.

Electroluminescent copolymers may comprise an electroluminescent region and at least one of a hole transporting region and an electron transporting region as disclosed in, for example, WO 00/55927 and US 6353083. If only one of a hole transporting region and electron transporting region is provided then the electroluminescent region may also provide the other of hole transport and electron transport functionality. Alternatively, an electroluminescent polymer may be blended with a hole transporting material and / or an electron transporting material. Polymers comprising one or more of a hole transporting repeat unit, electron transporting repeat unit and emissive repeat unit may provide said units in a polymer main-chain or polymer side-chain.

The different regions within such a polymer may be provided along the polymer backbone, as per US 6353083, or as groups pendant from the polymer backbone as per WO 01/62869.

The non-emissive polycyclic aromatic hydrocarbon containing polymers of the invention may be used as host materials for phosphorescent emitters, in which case the emission of the polymer / phosphorescent emitter composition will be shifted to the colour of emission of the phosphorescent material.

Preferred phosphorescent emitters include metal complexes comprising optionally substituted complexes of formula (26):

ML¹_{q}L²ᵣL³ₛ 26

wherein M is a metal; each of L¹, L² and L³ is a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L² and c is the number of coordination sites on L³.

Heavy elements M induce strong spin-orbit coupling to allow rapid intersystem crossing and emission from triplet or higher states (phosphorescence). Suitable heavy metals M include:
- lanthanide metals such as cerium, samarium, europium, terbium, dysprosium, thulium, erbium and neodymium; and
- d-block metals, in particular those in rows 2 and 3 i.e. elements 39 to 48 and 72 to 80, in particular ruthenium, rhodium, pallaidum, rhenium, osmium, iridium, platinum and gold.

Suitable coordinating groups for the f-block metals include oxygen or nitrogen donor systems such as carboxylic acids, 1,3-diketonates, hydroxy carboxylic acids, Schiff bases including acyl phenols and iminoacyl groups. As is known, luminescent lanthanide metal complexes require sensitizing group(s) which have the triplet excited energy level higher than the first excited state of the metal ion. Emission is from an f-f transition of the metal and so the emission colour is determined by the choice of the metal. The sharp emission is generally narrow, resulting in a pure colour emission useful for display applications.

The d-block metals are particularly suitable for emission from triplet excited states. These metals form organometallic complexes with carbon or nitrogen donors such as porphyrin or bidentate ligands of formula 27: 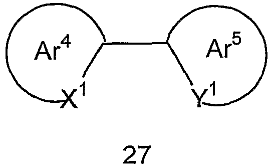 wherein Ar⁴ and Ar⁵ may be the same or different and are independently selected from optionally substituted aryl or heteroaryl; X¹ and Y¹ may be the same or different and are independently selected from carbon or nitrogen; and Ar⁴ and Ar⁵ may be fused together. Ligands wherein X¹ is carbon and Y¹ is nitrogen are particularly preferred.

Examples of bidentate ligands are illustrated below:

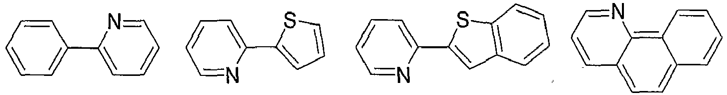

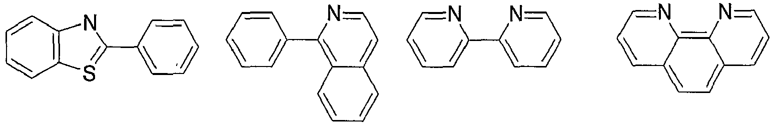

Each of Ar⁴ and Ar⁵ may carry one or more substituents. Two or more of these substituents may be linked to form a ring, for example an aromatic ring. Particularly preferred substituents include fluorine or trifluoromethyl which may be used to blue-shift the emission of the complex as disclosed in WO 02/45466, WO 02/44189, US 2002-117662 and US 2002-182441; alkyl or alkoxy groups as disclosed in JP 2002-324679; carbazole which may be used to assist hole transport to the complex when used as an emissive material as disclosed in WO 02/81448; bromine, chlorine or iodine which can serve to functionalise the ligand for attachment of further groups as disclosed in WO 02/68435 and EP 1245659; and dendrons which may be used to obtain or enhance solution processability of the metal complex as disclosed in WO 02/66552.

A light-emitting dendrimer typically comprises a light-emitting core bound to one or more dendrons, wherein each dendron comprises a branching point and two or more dendritic branches. Preferably, the dendron is at least partially conjugated, and at least one of the core and dendritic branches comprises an aryl or heteroaryl group. In one preferred embodiment, the branch group comprises

Other ligands suitable for use with d-block elements include diketonates, in particular acetylacetonate (acac); triarylphosphines and pyridine, each of which may be substituted.

Main group metal complexes show ligand based, or charge transfer emission. For these complexes, the emission colour is determined by the choice of ligand as well as the metal.

The host material and metal complex may be combined in the form of a physical blend. Alternatively, the metal complex may be chemically bound to the host material. In the case of a polymeric host, the metal complex may be chemically bound as a substituent attached to the polymer backbone, incorporated as a repeat unit in the polymer backbone or provided as an end-group of the polymer as disclosed in, for example, EP 1245659, WO 02/31896, WO 03/18653 and WO 03/22908.

A wide range of fluorescent low molecular weight metal complexes are known also and have been demonstrated in organic light emitting devices [see, e. g., Macromol. Sym. 125 (1997) 1-48, US-A 5,150,006, US-A 6,083,634 and US-A 5,432,014]. Again, a polymer comprising non-emissive polycyclic aromatic hydrocarbon units or end group(s) may be used as a host material for such emitters. Suitable ligands for di or trivalent metals include: oxinoids, e. g. with oxygen-nitrogen or oxygen-oxygen donating atoms, generally a ring nitrogen atom with a substituent oxygen atom, or a substituent nitrogen atom or oxygen atom with a substituent oxygen atom such as 8-hydroxyquinolate and hydroxyquinoxalinol-10-hydroxybenzo (h) quinolinato (II), benzazoles (III), schiff bases, azoindoles, chromone derivatives, 3-hydroxyflavone, and carboxylic acids such as salicylato amino carboxylates and ester carboxylates. Optional substituents include halogen, alkyl, alkoxy, haloalkyl, cyano, amino, amido, sulfonyl, carbonyl, aryl or heteroaryl on the (hetero) aromatic rings which may modify the emission colour.

### EXAMPLES

### Monomer Example 1

A monomer for forming a main chain perylene repeat unit was prepared according to the scheme below: 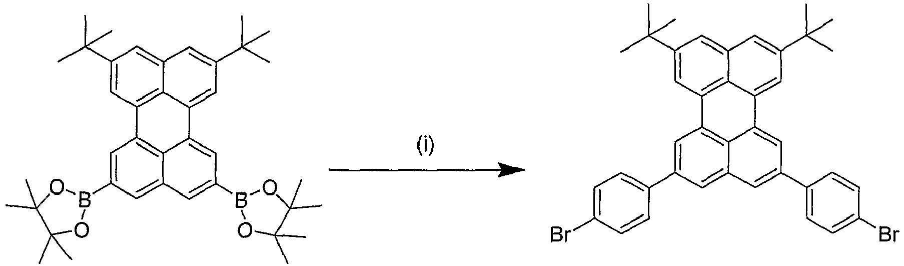
(i) 3 eq. 1-I-4-Br-C₆H₄, 0.2 eq. Pd(PPh₃)₄, 4 eq. Ag₂CO₃, anhyd. THF, reflux 2hr. Purified by column chromatography followed by sublimation and repeated recrystallisation.

### Monomer Example 2

An end-capping reactive material for forming an end-capping group of a polymer was prepared according to the scheme below: 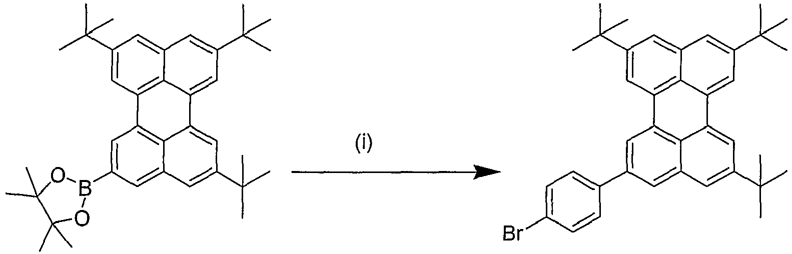
(i) 10 eq. 1-I-4-Br-C₆H₄, 0.1 eq. Pd(PPh₃)₄, 2 eq. Ag₂CO₃, anhyd. THF, reflux 3hr. Purified by column chromatography followed by sublimation and repeated recrystallisation.

### Monomer Example 3

A monomer comprising a pendent perylene group was prepared according to the method set out below: 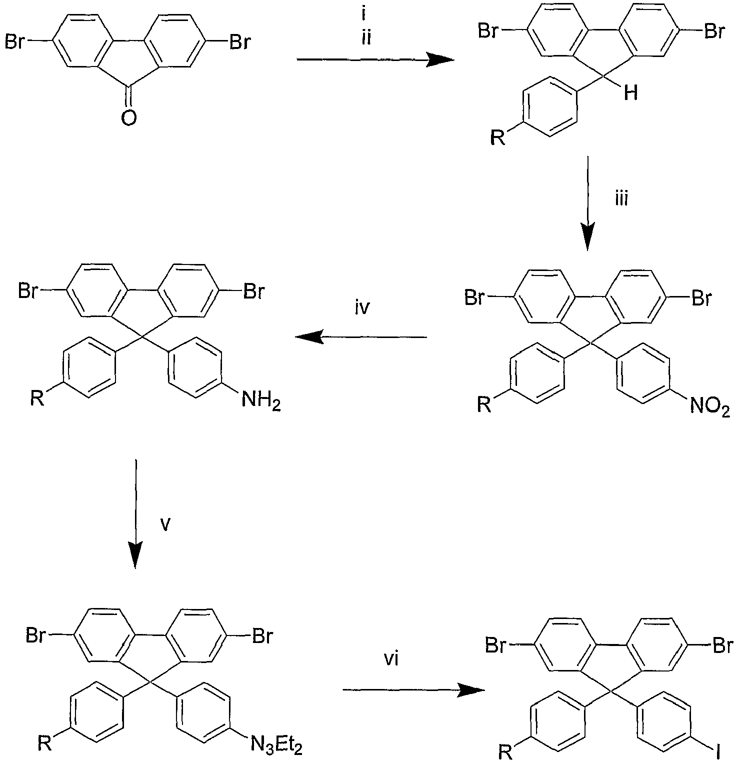
i) 8 eq. HexPh, 2eq. CF₃SO₃H, room temp. 45 °C, 3hr
ii) 0.2 eq. Sodium 3-mercaptopropan sulfinic acid, 45 °C, 6hr. HexPh removed by distillation. Product precipitated into methanol and recrystallised twice from IPA/toluene.
iii) 1.2 eq. 4-F-C₆H₄NO₂, 1.5 eq. K₂CO₃, DMF, 6h. Precipitated into water and dried.
iv) 3.75 eq. SnCl₂, EtOH, reflux, 12hr. 2/3 EtOH removed and pH raised to 10 with aq. NaOH. Aqueous work up with toluene, precipitated from toluene with 5 vol. eq. hexane.
v) Dissolved in 6M HCl / MeCN, cool to 0 °C. Added 1.05 eq. NaNO₂ (aq) dropwise. Stir for 1 hr at 0 °C. Added slowly to solution of 2 eq. K₂CO₃, 2 eq. NEt₂H at 0 °C. Stirred for 2hr at 0 °C. Warmed to room temp, extracted into CHCl₃. Purified by column chromatography.
vi) Excess Mel, 2 eq I₂ 80 °C 8hr. Remove Mel under reduced pressure, extract with CHCl₃, wash with Na₂S₂O₄. Purify by colum chromatography followed by repeated crystallisation from toluene/methanol. 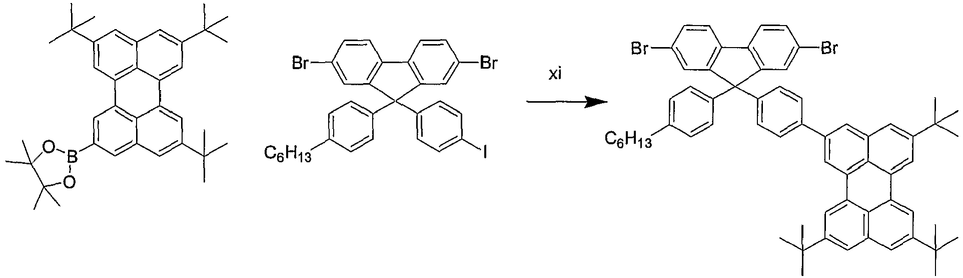
vii) 0.2 eq. Pd(PPh₃)₄, 2.5 eq. Cs₂CO₃, anhyd. DMF, room temp, 16h. Purified by column chromatography and repeated recrystallisation from ⁿBuOAc/MeOH.

### Polymer Example 1

A polymer comprising emissive units, fluorene units of formula 6, amine repeat units of formula 7, and a main chain polycyclic aromatic hydrocarbon derived from the monomer of Monomer Example 1 was prepared by Suzuki polymerisation as described in WO 00/53656.

### Polymer Example 2

A polymer comprising emissive units; fluorene units of formula 6, amine repeat units of formula 7, and a side chain polycyclic aromatic hydrocarbon derived from the monomer of Monomer Example 2 was prepared by Suzuki polymerisation as described in WO 00/53656.

### Polymer Example 3

A polymer comprising emissive units, fluorene units of formula 6, amine repeat units of formula 7, and an end capping group derived from the material of Monomer Example 3 was prepared by Suzuki polymerisation as described in WO 00/53656.

For the purpose of comparison, a polymer corresponding to Polymer Example 1 was prepared, except that the large polycyclic aromatic hydrocarbon was replaced by an amine of formula 7.

### Device Performance

Figure 2 shows a graph illustrating luminance vs time plots for several polymers according to the present invention in which non-emissive polycyclic aromatic hydrocarbon units have been incorporated (higher group of lines) and also, for comparison, corresponding polymers without large non-emissive polycyclic aromatic hydrocarbon units incorporated therein (lower group of lines). As can be seen from the plots, the polymers of the present invention have a significantly longer lifetime compared with the comparative examples.

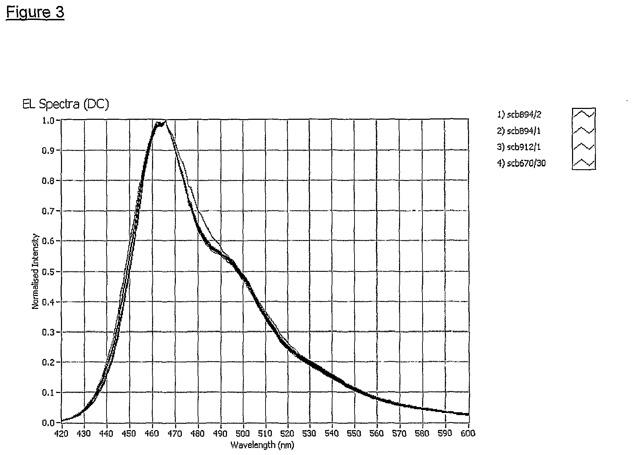

Figure 3 shows the emission spectra of the polymers. As can be seen from the plots, there is no significant difference in the emission spectra of the polymers of the present invention and the comparative examples.

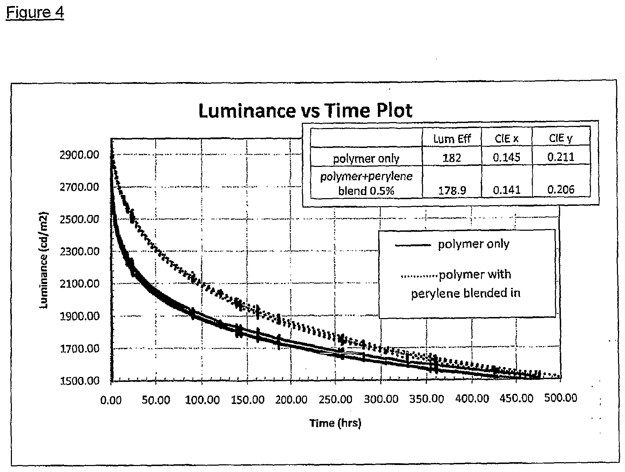

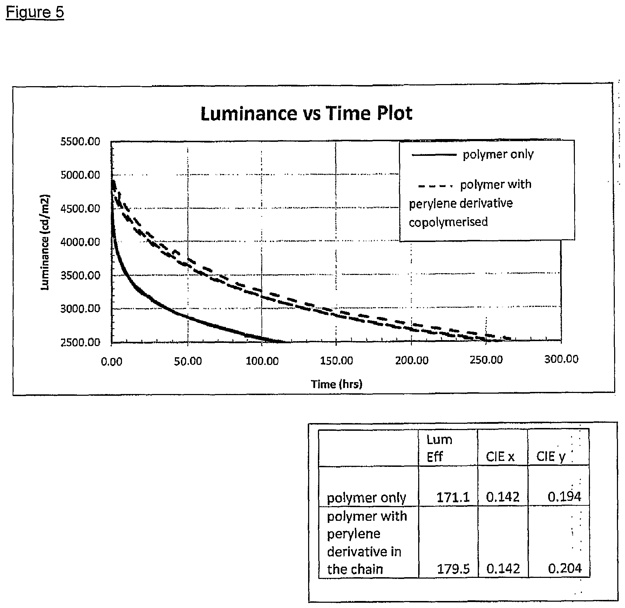

Figure 4 shows a graph illustrating luminance vs time plots for a polymer only (solid lines) and a polymer blended with perylene (dotted lines). Figure 5 shows a graph illustrating luminance vs time plots for a polymer only (solid lines) and a polymer according to the present invention in which non-emissive perylene derivative units have been incorporated (dotted lines). In Figures 4 and 5 the polymers contain electron transport units, hole transport units and emitter units. The device structure comprises the layered structure: anode / hole injection layer / hole transport layer / electroluminescent layer / cathode. As can be seen from the plots, when a perylene derivative is introduced either as a monomer or in a blend it improves the lifetime of the polymer. The effect has been found to be more pronounced in the copolymer as compared to the blend.

## Claims

1. A conjugated, blue-light emitting electroluminescent polymer comprising light-emissive repeat units and a non-emissive polycyclic aromatic hydrocarbon unit with greater than 12 aromatic sp2 hybridized carbon atoms, wherein the non-emissive polycyclic aromatic hydrocarbon unit comprises a structural unit having formula II: 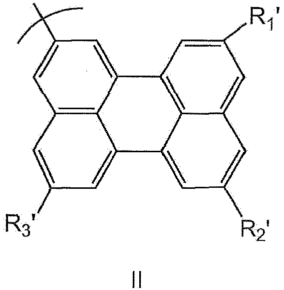 where R₁', R₂', and R₃' each independently represent an optional substituent, and the non-emissive polycyclic aromatic hydrocarbon unit is covalently bound as a side chain to the electroluminescent polymer main chain.

2. An electroluminescent polymer according to claim 1, wherein the non-emissive polycyclic aromatic hydrocarbon unit is connected to the backbone of the electroluminescent polymer via a spacer group.

3. An electroluminescent polymer according to claim 2, wherein the spacer group is phenyl.

4. An electroluminescent polymer according claim 2, wherein the spacer group is alkyl.

5. An electroluminescent polymer according to any one of the preceding claims, wherein the backbone of the electroluminescent polymer comprises a repeat unit having formula IV: 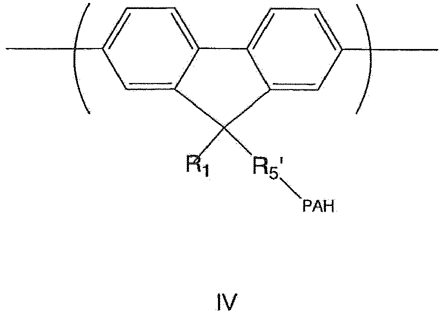 where R₁ represents hydrogen or optionally substituted alkyl, alkoxy, aryl, arylalkyl, heteroaryl or heteroaryl alkyl; R₅' is a spacer group; and PAH represents the non-emissive polycyclic aromatic hydrocarbon unit.

6. An electroluminescent polymer according to claim 5, wherein the repeat unit having formula IV is selected from formulae V to VIII: 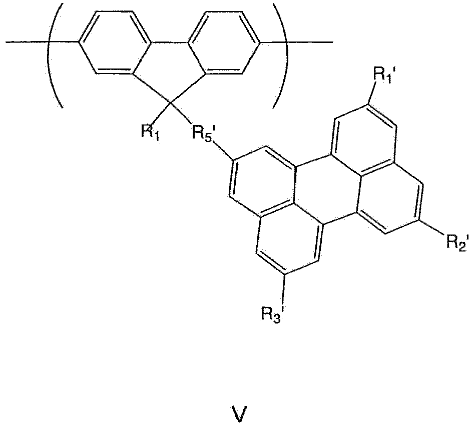 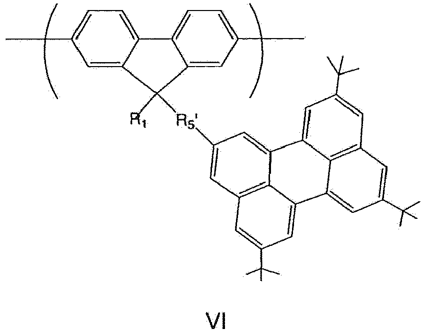 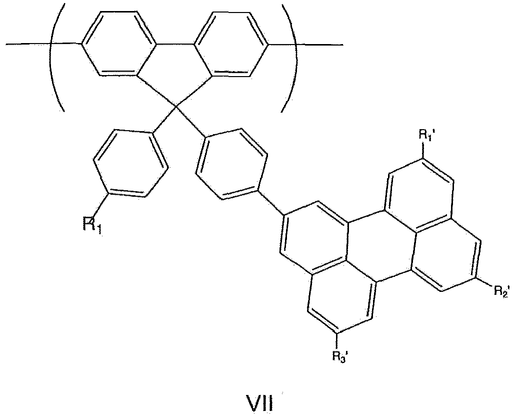 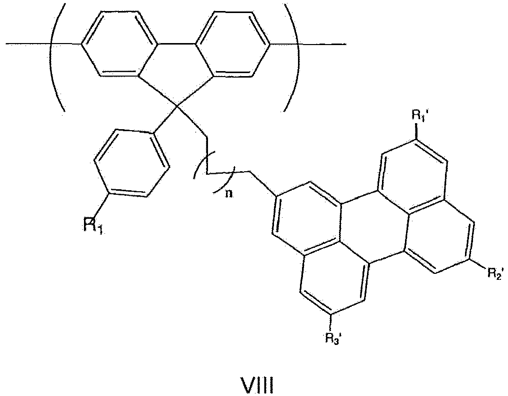 where R₁', R₂', and R₃' each independently represent an optional substituent; R₁ represents hydrogen or optionally substituted alkyl, alkoxy, aryl, arylalkyl, heteroaryl or heteroaryl alkyl; R₅' is a spacer group; and n is an integer from 1 to 10.

7. An electroluminescent polymer according to any preceding claim, wherein the non-emissive polycyclic aromatic hydrocarbon unit is provided in a concentration of less than 10 mol% of the total moles of repeat units in the electroluminescent polymer.

8. An electroluminescent polymer according to any one of claims 1 to 6, wherein the non-emissive polycyclic aromatic hydrocarbon unit is provided in a concentration of the less than 2 mol% of the total moles of repeat units in the electroluminescent polymer.

9. An electroluminescent polymer according to any one of claims 1 to 6, wherein the non-emissive polycyclic aromatic hydrocarbon unit is provided in a concentration of the less than 1 mol% of the total moles of repeat units in the electroluminescent polymer.

10. An electroluminescent polymer according to any preceding claim, comprising a conjugated main chain.

11. An organic-light emitting device (OLED) comprising an anode, a cathode, and an electroluminescent layer comprising an electroluminescent polymer as defined in any one of claims 1 to 10 between the anode and the cathode.

12. An OLED according to claim 11, comprising a conductive hole injection layer between the anode and the electroluminescent layer to assist hole injection from the anode into the electroluminescent layer.

13. A method of making an OLED as defined in claim 11 or claim 12 comprising a step of depositing an electroluminescent polymer as defined in any one of claims 1 to 7 from solution by solution processing to form a layer of the OLED.

14. A method according to claim 13, wherein the solution processing technique is spin-coating or inkjet printing.

## Patentansprüche

1. Konjugiertes, Blaulicht emittierendes elektrolumineszentes Polymer, das Licht-emissive Wiederholungseinheiten und eine nicht-emissive polyzyklische aromatische Kohlenwasserstoffeinheit mit mehr als 12 aromatischen sp2-hybridisierten Kohlenstoffatomen umfasst, wobei die nicht-emissive polyzyklische aromatische Kohlenwasserstoffeinheit eine Struktureinheit von Formel II umfasst: 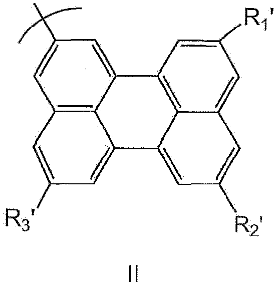 wobei R₁', R₂' und R₃' jeweils unabhängig einen optionalen Substituenten repräsentieren und die nicht-emissive polyzyklische aromatische Kohlenwasserstoffeinheit kovalent als Seitenkette an die elektrolumineszente Polymerhauptkette gebunden ist.

2. Elektrolumineszentes Polymer nach Anspruch 1, wobei die nicht-emissive polyzyklische aromatische Kohlenwasserstoffeinheit mit dem Gerüst des elektrolumineszenten Polymers über eine Abstandshaltergruppe verbunden ist.

3. Elektrolumineszentes Polymer nach Anspruch 2, wobei die Abstandshaltergruppe Phenyl ist.

4. Elektrolumineszentes Polymer nach Anspruch 2, wobei die Abstandshaltergruppe Alkyl ist.

5. Elektrolumineszentes Polymer nach einem der vorherigen Ansprüche, wobei das Gerüst des elektrolumineszenten Polymers eine Wiederholungseinheit von Formel IV umfasst: 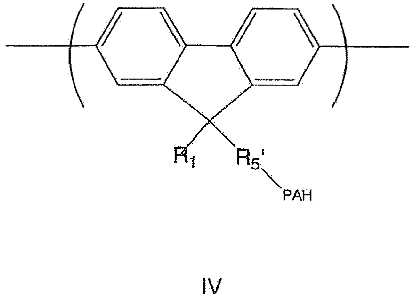 wobei R₁ Wasserstoff oder optional substituiertes Alkyl, Alkoxy, Aryl, Arylalkyl, Heteroaryl oder Heteroarylalkyl repräsentiert; R₅' eine Abstandshaltergruppe ist; und PAH die nicht-emissive polyzyklische aromatische Kohlenwasserstoffeinheit repräsentiert.

6. Elektrolumineszentes Polymer nach Anspruch 5, wobei die Wiederholungseinheit von Formel IV ausgewählt ist aus Formeln V bis VIII: 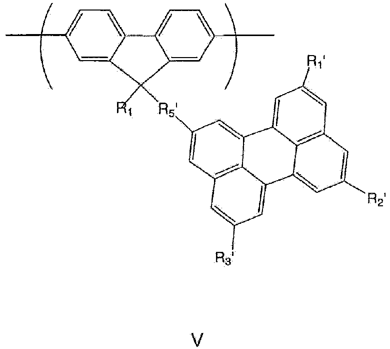 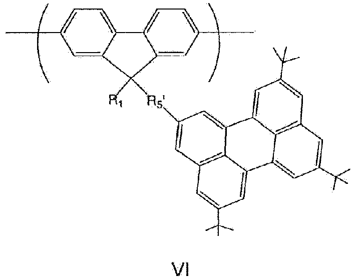 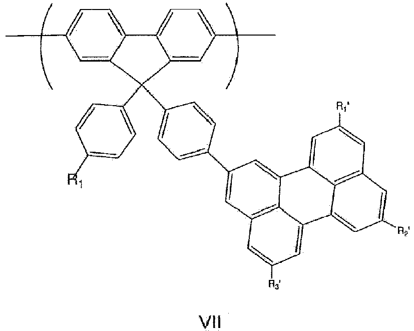 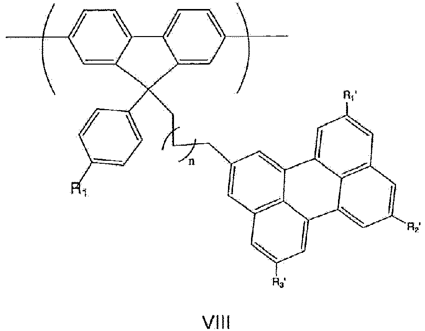 wobei R₁', R₂' und R₃' jeweils unabhängig einen optionalen Substituenten repräsentieren; R₁ Wasserstoff oder optional substituiertes Alkyl, Alkoxy, Aryl, Arylalkyl, Heteroaryl oder Heteroarylalkyl repräsentiert; R₅' eine Abstandshaltergruppe ist und n eine ganze Zahl von 1 bis 10 ist.

7. Elektrolumineszentes Polymer nach einem vorherigen Anspruch, wobei die nicht-emissive polyzyklische aromatische Kohlenwasserstoffeinheit in einer Konzentration von weniger als 10 Mol-% der Gesamtmole von Wiederholungseinheiten in dem elektrolumineszenten Polymer vorliegt.

8. Elektrolumineszentes Polymer nach einem der Ansprüche 1 bis 6, wobei die nicht-emissive polyzyklische aromatische Kohlenwasserstoffeinheit in einer Konzentration von weniger als 2 Mol-% der Gesamtmole von Wiederholungseinheiten in dem elektrolumineszenten Polymer vorliegt.

9. Elektrolumineszentes Polymer nach einem der Ansprüche 1 bis 6, wobei die nicht-emissive polyzyklische aromatische Kohlenwasserstoffeinheit in einer Konzentration von weniger als 1 Mol-% der Gesamtmole von Wiederholungseinheiten in dem elektrolumineszenten Polymer vorliegt.

10. Elektrolumineszentes Polymer nach einem vorherigen Anspruch, das eine konjugierte Hauptkette umfasst.

11. Organisches Licht-emittierendes Bauelement (OLED), das eine Anode, eine Katode und eine elektrolumineszente Schicht umfasst, die ein elektrolumineszentes Polymer nach einem der Ansprüche 1 bis 10 zwischen der Anode und der Katode umfasst.

12. OLED nach Anspruch 11, das eine leitende Lochinjektionsschicht zwischen der Anode und der elektrolumineszenten Schicht umfasst, um Lochinjektion von der Anode in die elektrolumineszente Schicht zu unterstützen.

13. Verfahren zur Herstellung eines OLED nach Anspruch 11 oder Anspruch 12, das einen Schritt des Absetzens eines elektrolumineszenten Polymers nach einem der Ansprüche 1 bis 7 aus einer Lösung durch Lösungsverarbeitung zum Bilden einer Schicht des OLED beinhaltet.

14. Verfahren nach Anspruch 13, wobei die Lösungsverarbeitungstechnik Schleuderbeschichtung oder Tintenstrahldrucken ist.

## Revendications

1. Polymère conjugué électroluminescent émettant de la lumière bleue comprenant des motifs répétés émetteurs de lumière et un motif hydrocarboné polycyclique aromatique non émetteur comportant plus de 12 atomes de carbone hybridés sp² aromatiques, dans lequel le motif hydrocarboné polycyclique aromatique non émetteur comprend un motif de structure répondant à la formule II : 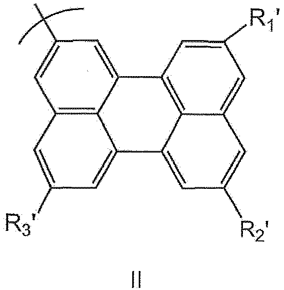 où R₁', R₂' et R₃' représentent chacun indépendamment un substituant facultatif, et le motif hydrocarboné polycyclique aromatique non émetteur est lié de façon covalente en tant que chaîne latérale à la chaîne principale du polymère électroluminescent.

2. Polymère électroluminescent selon la revendication 1, dans lequel le motif hydrocarboné polycyclique aromatique non émetteur est relié au squelette du polymère électroluminescent par l'intermédiaire d'un groupe espaceur.

3. Polymère électroluminescent selon la revendication 2, dans lequel le groupe espaceur est un groupe phényle.

4. Polymère électroluminescent selon la revendication 2, dans lequel le groupe espaceur est un groupe alkyle.

5. Polymère électroluminescent selon l'une quelconque des revendications précédentes, dans lequel le squelette du polymère électroluminescent comprend un motif répété répondant à la formule IV : 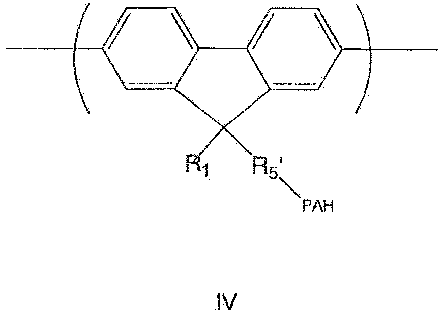 où R₁ représente l'atome d'hydrogène ou un groupe alkyle, alcoxy, aryle, arylalkyle, hétéroaryle ou hétéroarylalkyle éventuellement substitué ; R₅' est un groupe espaceur ; et PAH représente le motif hydrocarboné polycyclique aromatique non émetteur.

6. Polymère électroluminescent selon la revendication 5, dans lequel le motif répété répondant à la formule IV est choisi parmi les formules V à VIII : 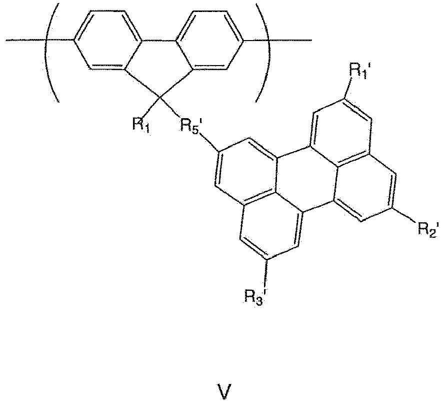 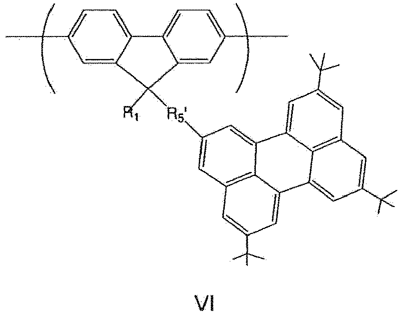 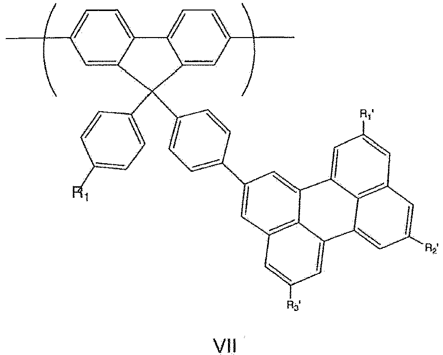 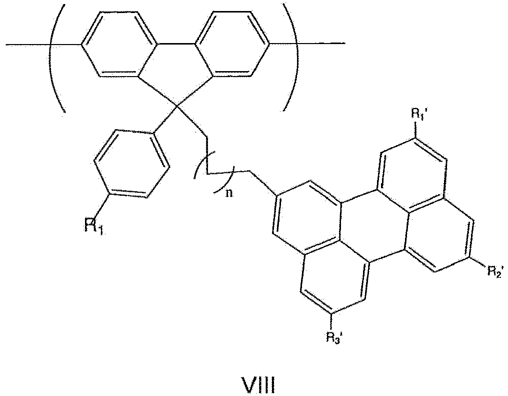 où R₁', R₂' et R₃' représentent chacun indépendamment un substituant facultatif ; R₁ représente l'atome d'hydrogène ou un groupe alkyle, alcoxy, aryle, arylalkyle, hétéroaryle ou hétéroarylalkyle éventuellement substitué ; R₅' est un groupe espaceur ; et n est un nombre entier de 1 à 10.

7. Polymère électroluminescent selon une quelconque revendication précédente, dans lequel le motif hydrocarboné polycyclique aromatique non émetteur est pourvu en une concentration de moins de 10 % en mole des moles totales de motifs répétés dans le polymère électroluminescent.

8. Polymère électroluminescent selon l'une quelconque des revendications 1 à 6, dans lequel le motif hydrocarboné polycyclique aromatique non émetteur est pourvu en une concentration de moins de 2 % en mole des moles totales de motifs répétés dans le polymère électroluminescent.

9. Polymère électroluminescent selon l'une quelconque des revendications 1 à 6, dans lequel le motif hydrocarboné polycyclique aromatique non émetteur est pourvu en une concentration de moins de 1 % en mole des moles totales de motifs répétés dans le polymère électroluminescent.

10. Polymère électroluminescent selon une quelconque revendication précédente, comprenant une chaîne principale conjuguée.

11. Dispositif électroluminescent organique (DELO) comprenant une anode, une cathode et une couche électroluminescente comprenant un polymère électroluminescent tel que défini dans l'une quelconque des revendications 1 à 10 entre l'anode et la cathode.

12. DELO selon la revendication 11, comprenant une couche d'injection de trous conductrice entre l'anode et la couche électroluminescente pour aider à l'injection de trous à partir de l'anode dans la couche électroluminescente.

13. Procédé de fabrication d'un DELO tel que défini dans la revendication 11 ou la revendication 12 comprenant une étape de dépôt d'un polymère électroluminescent tel que défini dans l'une quelconque des revendications 1 à 7 à partir d'une solution par traitement en solution pour former une couche du DELO.

14. Procédé selon la revendication 13, dans lequel la technique de traitement en solution est un dépôt à la tournette ou une impression par jet d'encre.
